(19) **Europäisches Patentamt**
**European Patent Office**
**Office européen des brevets**

(11) **EP 4 312 183 B1**

(12) **EUROPEAN PATENT SPECIFICATION**

(45) Date of publication and mention
of the grant of the patent:
**11.06.2025  Bulletin 2025/24**

(51) International Patent Classification (IPC):
**G06T 5/60** *(2024.01)*      **G01R 33/10** *(2006.01)*

(21) Application number: **22187009.0**

(52) Cooperative Patent Classification (CPC):
**G01R 33/10; G06T 5/60;** G06T 2207/20081;
G06T 2207/20084

(22) Date of filing: **26.07.2022**

(54) **DEEP NEURAL NETWORK BASED METHOD FOR ELECTROMAGNETIC SOURCE IMAGE RECONSTRUCTION**

AUF EINEM TIEFEN NEURONALEN NETZWERK BASIERENDES VERFAHREN ZUR BILDREKONSTRUKTION EINER ELEKTROMAGNETISCHEN QUELLE

PROCÉDÉ BASÉ SUR UN RÉSEAU NEURONAL PROFOND POUR LA RECONSTRUCTION D'UNE IMAGE DE SOURCE ÉLECTROMAGNÉTIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**31.01.2024  Bulletin 2024/05**

(73) Proprietors:
• **Qnami AG**
**4132 Muttenz (CH)**
• **Technische Universiteit Delft**
**2628 CN Delft (NL)**
• **Universität Basel**
**4001 Basel (CH)**

(72) Inventors:
• **Maletinsky, Patrick**
**8006 Zürich (CH)**
• **Broadway, David**
**Flemington, Victoria, 3031 (AU)**
• **Dubois, Adrien**
**Montréal, QC H1Y 3A6 (CA)**
• **Greplova, Eliska**
**2285 VV, Rijswijk (NL)**

(74) Representative: **P&TS SA (AG, Ltd.)**
**Avenue J.-J. Rousseau 4**
**P.O. Box 2848**
**2001 Neuchâtel (CH)**

(56) References cited:
**US-A1- 2021 311 151**

• **DIMITRIOS PANTAZIS ET AL: "MEG Source Localization via Deep Learning", ARXIV.ORG, CORNELL UNIVERSITY LIBRARY, 201 OLIN LIBRARY CORNELL UNIVERSITY ITHACA, NY 14853, December 2020 (2020-12-01), XP081827569**
• **WU XIN-JIE ET AL: "Research on image reconstruction algorithms based on autoencoder neural network of Restricted Boltzmann Machine (RBM)", FLOW MEASUREMENT AND INSTRUMENTATION, BUTTERWORTH-HEINEMANN, OXFORD, GB, vol. 80, 12 July 2021 (2021-07-12), XP086712351, ISSN: 0955-5986, [retrieved on 20210712], DOI: 10.1016/J.FLOWMEASINST.2021.102009**
• **GEXIN HUANG ET AL: "Electromagnetic Source Imaging via a Data-Synthesis-Based Convolutional Encoder-Decoder Network", ARXIV.ORG, CORNELL UNIVERSITY LIBRARY, 201 OLIN LIBRARY CORNELL UNIVERSITY ITHACA, NY 14853, 13 July 2022 (2022-07-13), XP091269504**
• **ONGIE GREGORY ET AL: "Deep Learning Techniques for Inverse Problems in Imaging", IEEE JOURNAL ON SELECTED AREAS IN INFORMATION THEORY, IEEE, vol. 1, no. 1, 6 May 2020 (2020-05-06), pages 39 - 56, XP011792704, DOI: 10.1109/JSAIT.2020.2991563**

**EP 4 312 183 B1**

- LUCAS ALICE ET AL: "Using Deep Neural Networks for Inverse Problems in Imaging: Beyond Analytical Methods", IEEE SIGNAL PROCESSING MAGAZINE, IEEE, USA, vol. 35, no. 1, 2018, pages 20 - 36, XP011675806, ISSN: 1053-5888, [retrieved on 20180109], DOI: 10.1109/ MSP.2017.2760358

- DUBOIS A E E ET AL: "Untrained physically informed neural network for image reconstruction of magnetic field sources", ARXIV.ORG, CORNELL UNIVERSITY LIBRARY, 201 OLIN LIBRARY CORNELL UNIVERSITY ITHACA, NY 14853, 27 July 2022 (2022-07-27), XP091281953

## Description

### Technical domain

The present invention concerns a computer-implemented method for reconstructing a digital image of an electromagnetic source, and a system for reconstructing a digital image of an electromagnetic source from electromagnetic imaging data.

### Related art

Predicting measurement outcomes from an underlying structure often follows directly from fundamental physical principles. However, a fundamental challenge is posed when trying to solve the inverse problem of inferring the underlying source-configuration based on measurement data. A key difficulty arises from the fact that such reconstructions often involve ill-posed transformations and that they are prone to numerical artefacts.

This situation is well illustrated in the field of image reconstruction, and particularly by the reconstruction of current flow or magnetization maps of an electromagnetic source based on electromagnetic measurements.

As an example, neuronal current sources generate magnetic fields outside the body that is detected in MEG (brain imaging) or MCG (heart imaging). The clinician or neuro researcher is interested in which patches of cortex get activated either during rest or in response to specific stimulus. However determining the strength, location, and spatial extent of the sources from magnetic field data is an ill-posed problem as there is an infinite set of sources that can give rise to any given magnetic field distribution.

The state of the art for solving this type of problems is as follows: first assume a particular parametric form of the sources (current dipoles, a multipole expansion, etc.) as well as a model for the sources and its conductivity. Then, depending on the model chosen there are then either analytical or numerical formulas relating a given source distribution to a magnetic field map outside the source.

There are two main classes of algorithms solving the inverse problem of going from a magnetic field map to a distribution of sources. The first class consists in parametric modelling which assumes a small and fixed number of sources whose location and orientation may vary. The problem can be solved using either non-linear least squares search or so-called beamforming approaches. The second class consists in imaging approaches: the entire sample surface is tesselated into around 100k positions and a source of fixed orientation is placed at each vertex. The problem is reduced to determining set of amplitudes that best fit the data. This problem is linear, however the system of equations is highly underdetermined, and some kind of prior knowledge or constraint is required to obtain a solution. These constrains are usually formulated in a Bayesian framework.

Deep neural networks are characterized as universal approximators having the potential to compute any non-linear function. Thus, they are good candidates in tackling reconstruction problems. While deep learning is the state of the art tool for solving many tasks in natural language processing or computer vision, serious improvements are needed to completely surpass traditional methods for reconstruction tasks. The main issue is that the knowledge provided to the model to learn is constrained to the training data set.

In the case of reconstructing an image of an electromagnetic source, the number of parameters (e.g., magnetization direction, magnetometer standoff, and magnetometer direction) influencing the reconstructed electromagnetic source image is high. Thus, it requires a large data set to train the network with every possible combination of control parameters. As such, there is a risk of training the network to only solve a subset of the total number of problems which may lead to the network converging to non-physical solutions. Moreover, the network is likely to encounter measurements not seen in the training data as well as the presence of unseen noise. This is particularly problematic as even tiny perturbations in the input can produce artefacts in the reconstructed output. Another challenge for deep learning is that the solution is based on a "black-box" which leaves out any explanations of the reconstruction process. The estimations on new samples are statistical inferences based on previous learning without warranty on the new output.

The document EYBPOSH H. et al. "DeepCGH: 3D computer-generated holography using deep learning", Opt. Express 28, 26636-26650, 2020, discloses an algorithm for hologram synthesis that employs a convolutional neural network to perform image plane holography with unsupervised training. In order to enable the unsupervised training of the model, the algorithm computes a virtual reconstruction of the hologram based on the estimated computer-generated hologram solution and compares it to the target intensity pattern. The efficiency of this algorithm relies on the quality and quantity of the training datasets as many deep learning algorithms.

Pantazis et al.: "MEG Source Localization via Deep Learning", ARXIV.ORG, Cornell University Library, 201 OLIN Library Cornell University Ithaca, NY 14853, December 2020 describes a deep learning solution to the problem of localization of magnetoencephalography (MEG) brain signals. The proposed deep model architectures are tuned for single and multiple time point MEG data, and can estimate varying numbers of dipole sources using a loss function that measures the misfit between the algorithm output and the training data label.

US 2021/311151 A1, Francavilla et al. describes acquiring MR signals associated with the sample from a measurement device. A predetermined set of coil magnetic field basis vectors associated with a surface surrounding a sample is accessed. A non-linear optimization problem for MR information associated with the sample and coefficients in representation of coil sensitivities is solved based on a forward model that uses the MR information as inputs and simulates response physics of the sample to output computed MR signals corresponding to the MR signals, the coefficients and the predetermined vector.

Wu et al.: "Research on image reconstruction algorithms based on autoencoder neural network of Restricted Boltzmann Machine (RBM)", Flow Measurement and Instrumentation, Butterworth-Heinemann, Oxford, GB, vol. 80, 12 July 2021 describes an electromagnetic tomography (EMT) image reconstruction algorithm based on autoencoder neural network of Restricted Boltzmann Machine (RBM).The encoding process of the encoder is equivalent to the object field detection process in the EMT system; the decoding process of the decoder is equivalent to the image reconstruction process.

Gexin et al.: "Electromagnetic Source Imaging via a Data-Synthesis-Based Convolutional Encoder-Decoder Network", ARXIV.ORG, Cornell University Library,201 OLIN Library Cornell University Ithaca, NY 14853, 13 July 2022 describes a data-synthesized spatio-temporally convolutional encoder-decoder network method termed DST-CedNet is proposed for Electromagnetic source imaging (ESI). DST-CedNet recasts ESI as a machine learning problem, where discriminative learning and latent-space representations are integrated in a convolutional encoder-decoder network (CedNet) to learn a robust mapping from the measured electroencephalography/ magnetoencephalography (EEG/MEG) signals to the brain activity. In particular, by incorporating prior knowledge regarding dynamical brain activities, a novel data synthesis strategy is devised to generate large-scale samples for effectively training CedNet. This stands in contrast to traditional ESI methods where the prior information is often enforced via constraints primarily aimed for mathematical convenience.

**Short disclosure of the invention**

An aim of the present invention is therefore to provide a method for reconstructing images of electromagnetic sources using neural networks which can be efficient without large training datasets.

Another aim of the invention to provide a method for reconstructing images of electromagnetic sources using neural networks which can be efficient with less prior knowledge of the electromagnetic source.

According to the invention, these aims are attained by the object of the attached claims, and especially by a computer implemented method of reconstructing a digital image (50) of an electromagnetic source (10) using a neural network (20) comprising the steps of

receiving an electromagnetic signal (11) acquired by an electromagnetic sensor (12) sensing said electromagnetic source (10),
providing the electromagnetic signal (11) as input into a neural network (20) parametrized by a set of parameters ($\theta$) for determining an estimated electromagnetic source vector (21) associated to the electromagnetic signal,
determining a loss function (30),
minimizing the loss function (30) by feed-forwarding the neural network (20) until a stop criterion is met so as to obtain an optimal electromagnetic source vector (40),
reconstructing a digital image (50) of the electromagnetic source (10) based on the optimal electromagnetic source vector (40),
**characterized in that** determining the loss function (30) comprises
computing an estimated electromagnetic signal (31) based on the estimated electromagnetic source vector (21), the loss function (30) depending on the estimated electromagnetic signal (31).

The present invention therefore propose to use a self-learning neural network to calculate the distribution and positions of electromagnetic sources. Rather than learning a mapping from an electromagnetic field to the electromagnetic sources based on a library of training data we propose to determine the weights and biases in the neural network 'on the fly' for each set of scan-data by repeatedly comparing the measured electromagnetic field map to the calculated electromagnetic field map, corresponding to an estimated source distribution. The difference between the measured electromagnetic map and the calculated electromagnetic map is used to iteratively train the network. This approach works no matter what forward model is used to calculate the electromagnetic map.

In a preferred embodiment, the loss function (30) may comprise a regularization term of the form

$$C_p = \|S - S_\theta\|,$$

where S is the electromagnetic signal (11), $S_\theta$ is the estimated electromagnetic signal (31), and $\| \cdot \|$ is a norm.

The electromagnetic signal (31) may represent a physical quantity chosen among: a magnetic field, an electrical field, the gradient of a magnetic field or the gradient of an electrical field.

The loss function (30) may further comprise a term of the form

$$C_r = C + \lambda C_p$$

where C is a standard loss function depending on the estimated electromagnetic source vector (21) and on a ground-truth digital image of an electromagnetic source (10), and $\lambda$ is a hyper-parameter controlling the influence of $C_p$.

The estimated electromagnetic source vector (21) may be determined using at least one of the parameters among: a value of an electromagnetic field, a first angle, a second angle, a first sensor angle, a second sensor angle, and a standoff distance between a sample and a sensor.

In a preferred embodiment, the neural network (20) may be a convolutional neural network, preferentially a convolutional neural network following a U-net architecture.

The neural network (20) may comprise at least one fully connected sub-network for estimating the first angle, the second angle, the first sensor angle and/or the second sensor.

The neural network (20) may be a fully connected neural network.

The computer-implemented method may further comprise a step of denoising the electromagnetic signal (11) executed prior to the step of providing the electromagnetic signal as input into the neural network.

The stop criterion is based on a threshold loss function value and/or on a signal to noise ratio metric.

According to the invention those aims are also attained by a system for reconstructing a digital image of an electromagnetic source from electromagnetic imaging data comprising:

> at least one electromagnetic sensor (12) for sensing an electromagnetic signal (11),
> means for carrying out the computer implemented method described above so as to obtain a digital image (50) of the electromagnetic source (10).

The at least one electromagnetic sensor (12) may comprise one or more of the following sensors: a scanning NV magnetometer, a widefield NV magnetometer, a superconducting quantum interference device, a hallbar, a magnetic resonance force microscope, and a tomographic sensor.

### Short description of the drawings

Exemplar embodiments of the invention are disclosed in the description and illustrated by the drawings in which:

- Fig.1 schematically illustrates a method for reconstructing a digital image of an electromagnetic source using a neural network.
- Fig.2 schematically illustrates a system of digital image reconstruction comprising at least one electromagnetic sensor and a neural network.

### Examples of embodiments of the present invention

The present invention concerns a computer-implemented method for reconstructing a digital image of an electromagnetic source based on a measure of an electromagnetic signal.

In the context of this disclosure, an electromagnetic source means any physical object emitting an electromagnetic field. The electromagnetic signal can correspond to a measure of the generated electromagnetic field or to a quantity depending on the electromagnetic field. If the source is a magnetic source generating a magnetic field B, the electromagnetic signal can be the magnetic field B, but it can also be for example the gradient ∇B of the magnetic field or other quantities related to the magnetic field. Similarly, if the source is an electrical source generating an electrical field E, the electromagnetic signal can be the electrical field E, but also the gradient ∇E of the electrical field.

The aim of the present method is to input the electromagnetic signal into a neural network which will output an estimation of a magnetization vector or of a polarization vector. Based on this estimation, an estimation of the electromagnetic signal is determined using the linear relation between either the magnetic field and the magnetization vector, or between the electrical field and the electric polarization vector. Finally a loss function depending on the electromagnetic signal and the estimated electromagnetic signal is determined and minimized to find an optimal estimated electromagnetic source vector which can be used to reconstruct the digital image of the electromagnetic source. This can for example serve to reconstruct magnetization maps of magnetic source or current density maps.

In the context of this disclosure, the term "vector" may refer to a unique vector or it may refer to a "vector field". As an example, the present method allows the reconstruction of an estimated electromagnetic source vector, which can be for example represent a magnetic field which is a vector field. In this case, the estimated electromagnetic source vector could be understood as a unique vector of a vector field, or as the vector field itself. The meaning of the term "vector" shall be clear for the person skilled in the art depending from the context in which it is used.

In a particular embodiment, in which the electromagnetic source is a magnetic source generating a magnetic field B, the relation between the signal and the source is best expressed in the Fourier space. Under the assumptions that the magnetization vector M = $M(x, y)$ is confined to a two-dimensional plane $(x, y)$ and that the stray field $B$ is measured in a parallel plane at an approximately known height $z'$, i.e. $B = B(x, y, z')$, this relation reads:

$$\begin{pmatrix} \widehat{B}_x \\ \widehat{B}_y \\ \widehat{B}_z \end{pmatrix} = -\frac{1}{\alpha} \underbrace{\begin{pmatrix} k_x^2/k & k_x k_y/k & ik_x \\ k_x k_y/k & k_y^2/k & ik_y \\ ik_x & ik_y & -k \end{pmatrix}}_{A} \begin{pmatrix} \widehat{M}_x \\ \widehat{M}_y \\ \widehat{M}_z \end{pmatrix},$$

where $\widehat{B}_x, \widehat{B}_y, \widehat{B}_z$ are the components of the Fourier transform of the magnetic field, $\widehat{M}_x, \widehat{M}_y, \widehat{M}_z$ are the components of the Fourier transform of the magnetization vector, $k_x, k_y$ are the components of the transfer matrix, $k = \sqrt{k_x^2 + k_y^2}$ and $\alpha = 2e^{kz'}/\mu_0$ contains an exponential that represents the propagator between the source and measurement planes. The assumptions on the magnetization vector and on the stray field are intended to obtain a simple mathematical expression and do not constitute any limitation.

The transformation from a magnetisation map to a magnetic field map is therefore a well-posed forward transformation with a unique solution. In contrast, the inverse problem of transforming from a magnetic field map to a magnetization map is ill-posed as the transformation matrix $A$ is singular (its determinant is equal to zero), such that there is an infinite number of solutions for $\widehat{M}$.

In another embodiment, the electromagnetic source is an electrical source, and the electromagnetic signal represents the electrical field $E$. In this case, there are linear systems similar to the one presented above for the Fourier transform of the magnetic field and magnetization vector, relating the Fourier transforms of the electrical field $E$ and of the electric polarization vector $P$.

The goal of the invention is to develop a neural network parametrized by a set of parameters $\theta$ that will learn to operate as the inverse of the transformation matrix $A^{-1}$.

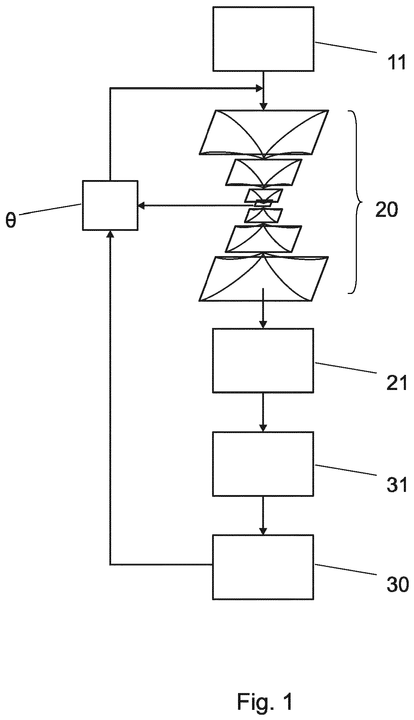

Fig. 1 illustrates a typical operation of the method of the present invention.

The first step of the present computer-implemented method consists in receiving an an electromagnetic signal 11 acquired by an electromagnetic sensor sensing said electromagnetic source. This may signify that a computer receives the electromagnetic signal from a sensor in real time or that the electromagnetic signal has been stored on a storing device and has been later received by a computer.

In the second step of the present method, the electromagnetic signal 11 is provided as input into a neural network 20 parametrized by a set of trainable parameters $\theta$. The neural network outputs an estimated electromagnetic source vector 21 associated with the electromagnetic signal 11. The estimated electromagnetic source vector 21 can be seen as an approximation of the target result which is a digital image 50 of the electromagnetic source 10.

In the case mentioned above in which the electromagnetic signal represents a magnetic field B, the estimated electromagnetic signal obtained in the second step can therefore be seen as an approximation of the magnetization vector $M_\theta$ parametrized by the set of parameters $\theta$.

The third step of the present method consists in determining a suitable loss function 30 to be able to train the neural network 20. This is a key step as it is the choice of the loss function 30 that allows the neural network 20 to be efficient without needing large training datasets.

The loss function 30 is determined by performing the well-posed forward transformation on the neural network output, i.e. on the estimated electromagnetic source vector 21, to transform it into an estimated electromagnetic signal 31. This new signal can therefore be seen as an approximation of the electromagnetic signal 11 based on the estimated electromagnetic source vector 21.

In the embodiment in which the electromagnetic signal 11 is the magnetic field $B$ itself, the estimated electromagnetic signal corresponds to $S_\theta = A\widehat{M}_\theta$, meaning that the transfer matrix $A$ has been applied to the estimated magnetization vector $\widehat{M}_\theta$ (up to a Fourier transformation).

The loss function 30 depends on both the electromagnetic signal 11 and the estimated electromagnetic signal 31. More precisely, the loss function 30 is designed to quantify the difference between the measured electromagnetic signal and the estimated electromagnetic signal. This difference can be quantified in various different ways using traditional norms such as $L_1$ or $L_2$ norms. Any type of norm may be used without departing from of scope of the invention as the key point here is the dependency of the loss function on the electromagnetic signal and the estimated electromagnetic signal.

This choice of this family of loss functions 30 allows the neural network 20 to be efficient without prior training on large datasets with ground truth values. Such a loss function only depends on the original electromagnetic signal 11 and on the estimated electromagnetic signal 31. That allows a model to train without the required ground-truth value. Moreover, it can directly learn on a single new input without previous training. So instead of traditionally training on a dataset and using the learned parameters to make new predictions, a network updates its parameters $\theta$ directly on the measured quantity which is the electromagnetic signal. The output of the network is not a statistical inference anymore but a solution depending on the well-posed forward transformation. Thus, the model's knowledge is not limited to a previous dataset but is directly taken from the input. Seeing that the loss function depends on the well-posed forward transformation, the proposed solution is ensured to be physically relevant. To this extent, the neural network is efficient while being untrained.

In the illustrative case of a magnetic source, this method fundamentally changes the ability to quantitatively determine from a stray-magnetic field image the magnetization of magnetic materials and current distributions in semiconductors, metals, or biological tissue. These capabilities are of scientific value, but even more so in the semiconductor industry (for the inspection of integrated circuits) or the magnetic memory industry for failure analysis and device development.

In a particular embodiment, the loss function 30 comprises a term of the form:

$$C_p = \|S - S_\theta\|,$$

where S is the electromagnetic signal 11, $S_\theta$ is the estimated electromagnetic signal 31, and $\| \cdot \|$ is a norm. As it can be seen from the above equation, the term $C_p$ only depends on the input electromagnetic signal S and on the estimated electromagnetic signal $S_\theta$. In particular, there is no dependence on any ground-truth value of the target electromagnetic source digital image.

The norm $\| \cdot \|$ can be any norm commonly used in machine learning or more generally, any norm matching the dimensions of its argument. In particular, the absolute mean norm $L_1$ or the Euclidean norm $L_2$ are good candidates, however, many other norms may serve to the purpose of the invention.

This loss function 30 can be seen as a regularization term. Usually, regularization acts on the parameters $\theta$ size in order to overcome overfitting. Where a physics regularization deals with the implementation of knowledge into the model. This added knowledge constraints the learning to a desired physical solution by adding a penalty term $C_p$ to a standard loss function $C$. In our case, this term is the forward solution for reconstructing the estimated electromagnetic signal from the estimated electromagnetic source vector. Thus, at the end of each iteration, the estimated electromagnetic signal is computed from the current estimated electromagnetic source vector. By doing so, it can be compared with the original electromagnetic signal at each iteration and be included in the loss function.

In another embodiment, the loss function 30 can comprise a term

$$C_r = C + \lambda C_p,$$

where C is a standard loss function depending on the estimated electromagnetic source vector 21 and on a ground-truth digital image of an electromagnetic source 10, and $\lambda$ is a hyper-parameter controlling the influence of $C_p$. As explained above, this loss function $C_r$ can be seen as a standard loss function C to which a regularization term $C_p$ has been added, for example to constraint the learning to a physically relevant solution.

In the presence of a training dataset containing ground-truth values, a loss function including both a standard loss function C depending on ground-truth values and on a loss function $C_p$ depending only on the input signal, can be trained by combining the traditional approach (based on the ground-truth values) using the dataset, with the feed-forward approach (based on each input electromagnetic signal).

As mentioned above, the electromagnetic signal 11 may represent a physical quantity selected among: a magnetic field, an electrical field, the gradient of a magnetic field or the gradient of an electrical field.

In the case in which the electromagnetic signal 11 is a gradient of a magnetic or electrical field, the neural network 20 still outputs an estimated electromagnetic source vector 21 that represents an estimated magnetization or electric polarization vector. Based on this, the estimated electromagnetic signal 31 can be reconstructed by applying the relevant forward transformation and taking the gradient of the result. The loss function 30 can then be determined based on the original (measured) gradient, i.e. the electromagnetic signal, and the estimated gradient, i.e. the estimated electromagnetic signal.

The estimated electromagnetic source vector 21 can be determined using at least one of the parameters among: a value of an electromagnetic field, a first angle, a second angle, a first sensor angle, a second sensor angle, and a standoff distance between a sample and a sensor.

In an embodiment, the parameters are the following: a value of a magnetic field, a first magnetization angle, a second magnetization angle, a first sensor angle, a second sensor angle and a standoff distance between a sample source and a sensor. In this case, the sensor is typically a magnetometer.

In another embodiment, the parameters are the following: a value of an electrical field, a first electric polarization angle, a second electric polarization angle, a first sensor angle, a second sensor angle, and a standoff distance between a sample and a sensor. In this case, the sensor is typically an electrometer.

The possibility to train the neural network directly on a single image makes it possible to use different architecture without facing a computational problem. In this main text, we used a convolutional neural network following a U-net architecture. Where the cost function was the mean average loss between the reconstructed electromagnetic source and the original one.

Since convolutional layer requires a fixed-size input, a border is added to the input image to match the correct format. In order to make sure this border is not taken into account into the reconstruction, a region of interest layer can be inserted to focus the learning of the network to the desired region.

Some of the parameters listed above (i.e. an electromagnetic field value, the first and second angle, the first and second sensor angle and the standoff distance between the sensor and the sample) used to determine the estimated electromagnetic source vector, can be deduced directly by the model. In particular, the two pairs of angles can be deduced by the neural network.

In a particular embodiment, a branch of the neural network can be dedicated to each of these parameters that can be deduced by the model. A fully-connected sub-network can therefore be dedicated to the learning of each one of these parameters.

In another embodiment, the neural network is itself a fully-connected network.

One issue with implementing any reconstruction method is noise in the original data can be amplified during the reconstruction process. Thus, data with excessive noise is often ruled as ineligible for reconstruction, requiring either additional measurement time or a new measurement to be taken. This reconstruction is no different, in fact, the ill-posed problem is known to amplify noise. With a trained neural network, one can generalize a model to get rid of the noise in the reconstruction. However, one still faces the risk that unseen perturbations will create artefacts in the reconstruction.

As the untrained neural network of the present invention learns on the input directly, the quality of the reconstruction is directly linked to the quality of the input. Thus, one can easily improve the reconstruction quality by minimizing the noise beforehand.

For this reason, the method may comprise a step of denoising the electromagnetic signal. This step is preferably executed before providing the electromagnetic signal as input into the neural network.

Isolating the denoising from the reconstruction is valuable, as it allows for the possibility of using noisy images without the need for additional training and facilitates double checking of the denoise process itself for loss of information. In contrast, a trained neural network model would have to learn the denoising process, and can thus generalize incorrectly for a given data set.

The longer the untrained model learns, the more noise is taken into account into the reconstruction. In an embodiment, a signal to noise ratio (SNR) metric can be used as a stop criterion for the learning in order to limit the amount of noise included in the reconstruction. Typically, once the SNR has reached a minimum, the learning stops even though the loss function can still be reduced.

Other stop criteria for determining when the learning of the network has to stop can be considered. A threshold loss function value can be chosen before or during the learning as stop criterion. Alternatively or complementarily, a number of iterations of the learning process can be set as a stop criterion.

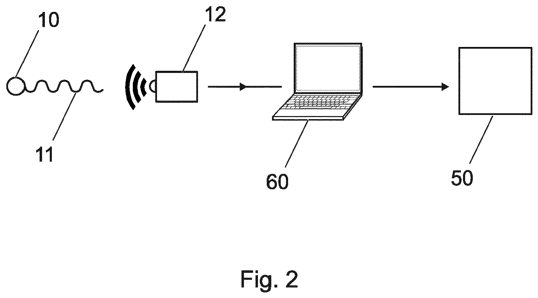

The present invention also concerns a system for reconstructing a digital image of an electromagnetic source from electromagnetic imaging data. As illustrated in Fig. 2, the system comprises at least one electromagnetic sensor 12 for sensing an electromagnetic signal 11, as well as means for carrying out the computer implemented method described above to obtain a digital image 50 of the electromagnetic source 10.

The at least one sensor can be any type of electromagnetic sensor or combinations of the like, including various types of magnetometers such as scanning NV magnetometers, widefield NV magnetometers, superconducting quantum interference devices (SQUID), hallbars, magnetic resonance force microscopes (MRFM), tomographic sensors or other imaging devices.

Means for carrying out the computer-implemented method include a processing unit 60 such as a tensor processing unit (TPU), a neural network processor (NNP), an intelligence processing unit (IPU), a vision processing unit (VPU) and/or graphics processing unit (GPU). It also includes a memory unit such as SSD and/or HDD memory units or RAM memory modules.

The at least one sensor may be connected to the processing unit and/or memory modules. Alternatively, the signals sensed by the at least one sensor can be stored in a database that can be later accessed by the processing unit.

Depending on the embodiment, certain acts, events, or functions of any of the algorithms described herein can be performed in a different sequence, can be added, merged, or left out altogether (for example, not all described acts or events are necessary for the practice of the methods). Moreover, in certain embodiments, acts or events can be performed concurrently, for instance, through multi-threaded processing, interrupt processing, or multiple processors or processor cores or on other parallel architectures, rather than sequentially. In addition, different tasks or processes can be performed by different machines or computing systems that can function together.

The various illustrative logical blocks and modules described in connection with the embodiments disclosed herein can be implemented or performed by a machine, a microprocessor, a state machine, a digital signal processor (DSP), an application specific integrated circuit (ASIC), an FPGA, or other programmable logic device, discrete gate or transistor logic, discrete hardware components, or any combination thereof designed to perform the functions described herein. A hardware processor can include electrical circuitry or digital logic circuitry configured to process computer-executable instructions. In another embodiment, a processor includes an FPGA or other programmable device that performs logic operations without processing computer-executable instructions. A processor can also be implemented as a combination of computing devices, e.g., a combination of a DSP and a microprocessor, a plurality of microprocessors, one or more microprocessors in conjunction with a DSP core, or any other such configuration. A computing environment can include any type of computer system, including, but not limited to, a computer system based on a microprocessor, a mainframe computer, a digital signal processor, a portable computing device, a device controller, or a computational engine within an appliance, to name a few.

The steps of a method, process, or algorithm described in connection with the embodiments disclosed herein can be embodied directly in hardware, in a software module stored in one or more memory devices and executed by one or more processors, or in a combination of the two. A software module can reside in RAM memory, flash memory, ROM memory, EPROM memory, EEPROM memory, registers, hard disk, a removable disk, a CD-ROM, or any other form of non-transitory computer-readable storage medium, media, or physical computer storage known in the art. An example storage medium can be coupled to the processor such that the processor can read information from, and write information to, the storage medium. In the alternative, the storage medium can be integral to the processor. The storage medium can be volatile or nonvolatile. The processor and the storage medium can reside in an ASIC.

Conditional language used herein, such as, among others, "can," "might," "may," "e.g.," and the like, unless specifically stated otherwise, or otherwise understood within the context as used, is generally intended to convey that certain embodiments include, while other embodiments do not include, certain features, elements or states. Thus, such conditional language is not generally intended to imply that features, elements or states are in any way required for one or more embodiments or that one or more embodiments necessarily include logic for deciding, with or without author input or prompting, whether these features, elements or states are included or are to be performed in any particular embodiment. The terms "comprising," "including," "having," and the like are synonymous and are used inclusively, in an open-ended fashion, and do not exclude additional elements, features, acts, operations, and so forth. Also, the term "or" is used in its inclusive sense (and not in its exclusive sense) so that when used, for example, to connect a list of elements, the term "or" means one, some, or all of the elements in the list. Further, the term "each," as used herein, in addition to having its ordinary meaning, can mean any subset of a set of elements to which the term "each" is applied.

**List of reference numerals**

| | |
|---|---|
| 10 | Electromagnetic source |
| 11 | Electromagnetic signal |
| 12 | Electromagnetic sensor |
| 20 | Neural network |
| 21 | Estimated electromagnetic source vector |
| 30 | Loss function |
| 31 | Estimated electromagnetic signal |
| 40 | Optimal electromagnetic source vector |
| 50 | Digital image |
| 60 | Computing unit |

**Claims**

1. A computer implemented method of reconstructing a digital image (50) of an electromagnetic source (10) using a neural network (20) comprising the steps of

   receiving an electromagnetic signal (11) acquired by an electromagnetic sensor (12) sensing said electromagnetic source (10),

providing the electromagnetic signal (11) as input into a neural network (20) parametrized by a set of parameters (θ) and obtaining as an output of the neural network (20), an estimated electromagnetic source vector (21) associated to the electromagnetic signal,

determining a loss function (30),

minimizing the loss function (30) by feed-forwarding the neural network (20) until a stop criterion is met so as to obtain an optimal electromagnetic source vector (40),

reconstructing a digital image (50) of the electromagnetic source (10) based on the optimal electromagnetic source vector (40),

**characterized in that** determining the loss function (30) comprises

computing an estimated electromagnetic signal (31) by applying a well-posed forward transformation on the estimated electromagnetic source vector (21), the loss function (30) depending on the electromagnetic signal (11) and the estimated electromagnetic signal (31).

2. Computer implemented method according to claim 1, wherein the loss function (30) comprises a regularization term of the form

$$C_p = \|S - S_\theta\|,$$

where S is the electromagnetic signal (11), $S_\theta$ is the estimated electromagnetic signal (31), and $\|\cdot\|$ is a norm.

3. Computer implemented method according to the preceding claim wherein said electromagnetic signal (31) represents a physical quantity chosen among: a magnetic field, an electrical field, the gradient of a magnetic field or the gradient of an electrical field.

4. Computer implemented method according to any of the claim 2 to 3, wherein the loss function (30) further comprises a term of the form

$$C_r = C + \lambda C_p$$

where $C$ is a standard loss function depending on the estimated electromagnetic source (21) and on a ground-truth digital image of an electromagnetic source (10), and $\lambda$ is a hyper-parameter controlling the influence of $C_p$.

5. Computer implemented method according to any of the preceding claims, wherein the estimated electromagnetic source vector (21) is determined using at least one of the parameters among: a value of an electromagnetic field, a first angle, a second angle, a first sensor angle, a second sensor angle, and a standoff distance between a sample and a sensor.

6. Computer implemented method according to any of the preceding claims, wherein the neural network (20) is a convolutional neural network, preferentially a convolutional neural network following a U-net architecture.

7. Computer implemented method according to claim 5, wherein the neural network (20) comprises at least one fully connected sub-network for estimating the first angle, the second angle, the first sensor angle and/or the second sensor.

8. Computer implemented method according to any of the claims 1 to 4, wherein the neural network (20) is a fully connected neural network.

9. Computer implemented method according to any of the preceding claims, further comprising a step of denoising the electromagnetic signal (11) prior to the step of providing the electromagnetic signal as input into the neural network.

10. Computer implemented method according to any of the preceding claims, wherein said the minimizing of the loss function (30) by feed-forwarding the neural network (20) is stopped based on a stop criterion depending on a threshold loss function value and/or on a signal to noise ratio metric.

11. A system for reconstructing a digital image of an electromagnetic source from electromagnetic imaging data comprising:

at least one electromagnetic sensor (12) for sensing an electromagnetic signal (11),
means for carrying out the computer implemented method of claims 1 to 10 so as to obtain a digital image (50) of the electromagnetic source (10).

12. System according to claim 11, wherein the at least one electromagnetic sensor (12) comprises one or more of the following sensors: a scanning NV magnetometer, a widefield NV magnetometer, a superconducting quantum interference device, a hallbar, a magnetic resonance force microscope, and a tomographic sensor.

**Patentansprüche**

1. Computer-implementiertes Verfahren zur Rekonstruktion eines digitalen Bildes (50) einer elektromagnetischen Quelle (10) unter Verwendung eines neuronalen Netzwerks (20), die folgenden Schritte umfassend:

   - Empfangen eines elektromagnetischen Signals (11), das von einem elektromagnetischen Sensor (12) erfasst wird, der die elektromagnetische Quelle (10) erfasst,
   - Bereitstellen des elektromagnetischen Signals (11) als Eingabe in ein neuronales Netzwerk (20), das durch einen Satz von Parametern ($\theta$) parametrisiert ist, und Erhalten einer geschätzte elektromagnetische Quelle (21), die dem elektromagnetischen Signal zugeordnet ist, als eine Ausgabe des neuronalen Netzwerks (20),
   - Bestimmen einer Verlustfunktion (30),
   - Minimierung der Verlustfunktion (30) durch Vorwärtskopplung des neuronalen Netzwerks (20) bis ein Stoppkriterium erfüllt ist, um einen optimalen elektromagnetischen Quellenvektor (40) zu erhalten,
   - Rekonstruktion eines digitalen Bildes (50) der elektromagnetischen Quelle (10) basierend auf dem optimalen elektromagnetischen Quellenvektor (40),

   **dadurch gekennzeichnet, dass** das Bestimmen der Verlustfunktion (30) ein Berechnen eines geschätzten elektromagnetischen Signals (31) durch Anwendung einer korrekt gestellten Vorwärtsfunktion auf der Grundlage des geschätzten elektromagnetischen Quellenvektors (21) umfasst, wobei die Verlustfunktion (30) von dem geschätzten elektromagnetischen Signal (31) abhängt.

2. Das Computer-implementierte Verfahren nach Anspruch 1, wobei die Verlustfunktion (30) einen Regularisierungsterm der folgenden Form umfasst

$$C_p = \|S - S_\theta\|,$$

   wobei S das elektromagnetische Signal (11), $S_\theta$ das geschätzte elektromagnetische Signal (31) und $\| \cdot \|$ eine Norm ist.

3. Das Computer-implementierte Verfahren nach dem vorhergehenden Anspruch, wobei das elektromagnetische Signal (31) eine physikalische Größe darstellt, die ausgewählt wird aus: einem Magnetfeld, einem elektrischen Feld, dem Gradienten eines Magnetfeldes oder dem Gradienten eines elektrischen Feldes.

4. Das Computerimplementierte Verfahren nach einem der Ansprüche 2 bis 3, wobei die Verlustfunktion (30) ferner einen Term der Form

$$C_r = C + \lambda C_p$$

   umfasst, wobei C eine Standard-Verlustfunktion ist, die von der geschätzten elektromagnetischen Quelle (21) und von einem echten digitalen Bild einer elektromagnetischen Quelle (10) abhängt, und wobei $\lambda$ ein Hyper-Parameter ist, der den Einfluss von $C_p$ kontrolliert.

5. Das Computer-implementierte Verfahren nach einem der vorhergehenden Ansprüche, wobei der geschätzte elektromagnetische Quellenvektor (21) unter Verwendung mindestens eines der folgenden Parameter bestimmt wird: ein Wert eines elektromagnetischen Feldes, ein erster Winkel, ein zweiter Winkel, ein erster Sensorwinkel, ein zweiter Sensorwinkel und ein Sicherheitsabstand zwischen einer Probe und einem Sensor.

6. Das Computer-implementierte Verfahren nach einem der vorhergehenden Ansprüche, wobei das neuronale Netzwerk (20) ein konvolutionales neuronales Netzwerk ist, vorzugsweise ein konvolutionales neuronales Netzwerk, das einer U-Netz-Architektur folgt.

7. Das Computer-implementierte Verfahren nach Anspruch 5, wobei das neuronale Netzwerk (20) mindestens ein vollständig verbundenes Teilnetzwerk zur Schätzung des ersten Winkels, des zweiten Winkels, des ersten Sensorwinkels und/oder des zweiten Sensors umfasst.

8. Das Computerimplementierte Verfahren nach einem der Ansprüche 1 bis 4, wobei das neuronale Netzwerk (20) ein vollständig verbundenes neuronales Netzwerk ist.

9. Das Computer-implementiertes Verfahren nach einem der vorhergehenden Ansprüche, das ferner einen Schritt des Rauschunterdrückens des elektromagnetischen Signals (11) vor dem Schritt des Bereitstellens des elektromagnetischen Signals als Eingabe in das neuronale Netzwerk umfasst.

10. Das Computer-implementierte Verfahren nach einem der vorhergehenden Ansprüche, wobei die Minimierung der Verlustfunktion (30) durch Vorwärtskopplung des neuronalen Netzwerks (20) auf der Grundlage eines Stoppkriteriums gestoppt wird, das von einem Schwellenwert der Verlustfunktion und/oder von einer Signal-Rausch Verhältnismetrik abhängt.

11. Ein System zur Rekonstruktion eines digitalen Bildes einer elektromagnetischen Quelle aus elektromagnetischen Abbildungsdaten, umfassend:

   mindestens einem elektromagnetischen Sensor (12) zum Erfassen eines elektromagnetischen Signals (11),
   Mittel zum Ausführen des Computer-implementierten Verfahrens nach einem der Ansprüche 1 bis 10, um ein digitales Bild (50) der elektromagnetischen Quelle (10) zu erhalten.

12. Das System nach Anspruch 11, wobei der mindestens eine elektromagnetische Sensor (12) einen oder mehrere der folgenden Sensoren umfasst: ein NV-Rastermagnetometer, ein NV-Weitfeldmagnetometer, eine supraleitende Quanteninterferenzvorrichtung, einen Hallbar, ein Magnetresonanz-Kraftmikroskop und einen tomographischen Sensor.

**Revendications**

1. Méthode mise en œuvre par ordinateur pour la reconstruction d'une image digitale (50) d'une source électromagnétique (10) en utilisant un réseau de neurones (20) comprenant les étapes de

   recevoir un signal électromagnétique (11) obtenu par un capteur électromagnétique (12) mesurant ladite source électromagnétique (10),
   fournir le signal électromagnétique (11) en entrée à un réseau de neurones (20) paramétrisé par un ensemble de paramètres ($\theta$) et obtenir en sortie du réseau de neurones (20), un vecteur de source électromagnétique estimé (21) associé au signal électromagnétique,
   déterminer une fonction de perte (30),
   minimiser la fonction de perte (30) par propagation avant du réseau de neurones (20) jusqu'à ce qu'une condition d'arrêt soit remplie de manière à obtenir un vecteur de source électromagnétique optimal (40),
   reconstruire une image digitale (50) de la source électromagnétique (10) sur la base du vecteur de source électromagnétique optimal (40),

   **caractérisée en ce que** déterminer la fonction de perte (30) comprend :
   calculer un signal électromagnétique estimé (31) en appliquant une transformation linéaire bien-posée au vecteur de source électromagnétique estimé (21), la fonction de perte (30) dépendant du signal électromagnétique et du signal électromagnétique estimé (31).

2. Méthode mise en œuvre par ordinateur selon la revendication 1, dans laquelle la fonction de perte (30) comprend un terme de régularisation de la forme

$$C_p = \|S - S_\theta\|,$$

où S est le signal électromagnétique (11), $S_\theta$ est le signal électromagnétique estimé (31), et $\| \cdot \|$ est une norme.

3.  Méthode mise en œuvre par ordinateur selon la revendication précédente, dans laquelle ledit signal électromagnétique (31) représente une quantité physique choisie parmi : un champ magnétique, un champ électrique, le gradient d'un champ magnétique ou le gradient d'un champ électrique.

4.  Méthode mise en œuvre par ordinateur selon l'une des revendications 2 à 3, dans laquelle la fonction de perte (30) comprend en outre un terme de la forme

$$C_r = C + \lambda C_p$$

où C est une fonction de perte standard dépendant du de source électromagnétique estimé (21) et d'une image digitale de référence d'une source électromagnétique (10), et $\lambda$ est un hyperparamètre contrôlant l'influence de $C_p$.

5.  Méthode mise en œuvre par ordinateur selon l'une des revendications précédentes, dans laquelle le vecteur de source électromagnétique estimé (21) est déterminé en utilisant au moins un paramètre sélectionné parmi : une valeur d'un champ magnétique, un premier angle, un premier angle de capteur, un deuxième angle de capteur, et une distance de sécurité entre un échantillon et un capteur.

6.  Méthode mise en œuvre par ordinateur selon l'une des revendications précédentes, dans laquelle le réseau de neurones (20) est un réseau de neurones convolutif, de préférence un réseau de neurones convolutif avec une architecture U-net.

7.  Méthode mise en œuvre par ordinateur selon la revendication 5, dans laquelle le réseau de neurones (20) comprend au moins un sous-réseau totalement connecté pour estimer le premier angle, le deuxième angle, le premier angle de capteur et/ou le deuxième angle de capteur.

8.  Méthode mise en œuvre par ordinateur selon l'une des revendications 1 à 4, dans laquelle le réseau de neurones (20) est un réseau de neurones totalement connecté.

9.  Méthode mise en œuvre par ordinateur selon l'une des revendications précédentes, comprenant en outre une étape de débruitage du signal électromagnétique (11) avant l'étape de fournir le signal électromagnétique en entrée au réseau de neurones (20).

10. Méthode mise en œuvre par ordinateur selon l'une des revendications précédentes, dans laquelle ladite minimisation de la fonction de perte (30) par propagation avant du réseau de neurones (20) est arrêtée sur la base d'une condition d'arrêt dépendant d'une valeur seuil de la fonction de perte et/ou d'une métrique de rapport signal/bruit.

11. Un système pour la reconstruction d'une image digitale d'une source électromagnétique sur la base de données d'imagerie électromagnétique comprenant :

    au moins un capteur électromagnétique (12) pour mesurer un signal électromagnétique (11),
    des moyens d'exécution de la méthode mise en œuvre par ordinateur selon l'une des revendications 1 à 10 de manière à obtenir une image digitale (50) de la source électromagnétique (10).

12. Système selon la revendication 11, dans lequel le au moins un capteur électromagnétique comprend au moins parmi les capteurs suivants : un magnétomètre NV à balayage, un magnétomètre NV à champ large, un dispositif d'interférence quantique supraconducteur, une barre de Hall, un microscope à force de résonance magnétique et un capteur tomographique.

Fig. 1

EP 4 312 183 B1

10

12

11

60

50

Fig. 2

15

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

• US 2021311151 A1, Francavilla

### Non-patent literature cited in the description

• **EYBPOSH H. et al.** DeepCGH: 3D computer-generated holography using deep learning. *Opt. Express*, 2020, vol. 28, 26636-26650
• MEG Source Localization via Deep Learning. **PANTAZIS et al.** ARXIV.ORG. Cornell University Library, December 2020
• **WU et al.** Research on image reconstruction algorithms based on autoencoder neural network of Restricted Boltzmann Machine (RBM). *Flow Measurement and Instrumentation, Butterworth-Heinemann*, 12 July 2021, vol. 80
• Electromagnetic Source Imaging via a Data-Synthesis-Based Convolutional Encoder-Decoder Network. **GEXIN et al.** ARXIV.ORG. Cornell University Library, 13 July 2022